# EUROPÄISCHE PATENTSCHRIFT

(11) **EP 2 735 540 B1**
(45) Veröffentlichungstag und Bekanntmachung des Hinweises auf die Patenterteilung: **12.11.2014**
(21) Anmeldenummer: 12193894.8
(22) Anmeldetag: 22.11.2012
(51) Int. Cl.: B81C 3/00, G04B 13/02

(54) **Zusammengesetztes mikromechanisches Bauteil mit Beschichtung, Verfahren zu dessen Herstellung sowie dessen Verwendung**
Compound micromechanical component having coating, method for producing same, and use thereof
Composant micromécanique composite ayant un revêtement, son procédé de fabrication et son utilisation

(43) Veröffentlichungstag der Anmeldung: 28.05.2014
(73) Patentinhaber: Diamaze Microtechnology S.A., 2300 La Chaux-de-Fonds (CH); GFD Gesellschaft für Diamantprodukte mbH, 89081 Ulm (DE)
(72) Erfinder: Gluche, Peter, 89287 Bellenberg (DE); Gretzschel, Ralph, 89231 Neu-Ulm/Offenhausen (DE)
(74) Vertreter: Pfenning, Meinig & Partner GbR

(56) Entgegenhaltungen:
- CH-A2- 699 680
- ASLAM D M ET AL: "The Fabrication of All-Diamond Packaging Panels With Built-In Interconnects for Wireless Integrated Microsystems", JOURNAL OF MICROELECTROMECHANICAL SYSTEMS, IEEE SERVICE CENTER, US, Bd. 13, Nr. 3, 1. Juni 2004 (2004-06-01), Seiten 396-405, XP011113560, ISSN: 1057-7157, DOI: 10.1109/JMEMS.2004.828739

## Beschreibung

Die Erfindung betrifft ein mikromechanisches Bauteil, das modular aus mehreren Bauteilkomponenten aufgebaut ist, wobei jede Bauteilkomponente mit mindestens einer weiteren Bauteilkomponente über mindestens eine Kontaktfläche in Kontakt steht. Die einzelnen Bauteilkomponenten sind dabei mittels einer zumindest bereichsweisen Beschichtung der Bauteiloberfläche formschlüssig zu dem mikromechanischen Bauteil verbunden. Ebenso betrifft die Erfindung ein Verfahren zur Herstellung dieses mikromechanischen Bauteils. Die mikromechanischen Bauteile finden Verwendung als Uhrwerksbauteile.

Gemäß dem Stand der Technik werden mikromechanische Bauteile üblicherweise aus Metallen oder anderen Festkörpern hergestellt. Es wurden allerdings bereits mikromechanische Bauteile aus Diamant gefertigt, die Abmessungen aufweisen, wie sie beispielsweise für den Einsatz in einer Uhr benötigt werden. Bisherige, aus Diamant gefertigte mikromechanische Bauteile werden dabei so hergestellt, dass zuerst über ein CVD-Verfahren Diamant auf einem flachen bzw. scheibenförmigen Substrat abgeschieden wird. Dies kann bis zu einer Stärke von etwa 300 µm erfolgen.

So sind aus der WO 2004/092049 mikromechanische Uhrwerkbauteile sowie ein Verfahren zu deren Herstellung bekannt. Hierbei handelt es sich um mikromechanische Bauteile aus Diamant, wobei erstmals mikromechanische Uhrwerkbauteile bereitgestellt werden konnte, deren Oberflächen im Wesentlichen senkrecht aufeinander stehen. Die so hergestellten mikromechanischen Bauteile weisen sehr glatte Kanten und Flächen auf, wodurch die Abnutzen des Gleit- bzw. Reibpartners, z.B. eines Zahnrades, sehr gering ist.

Aus der US 2010/0214880 A1 ist ein mikromechanisches Bauteil aus Silicium bekannt, wobei die Bauteile an der Oberfläche mit Siliciumdioxid zur Verbesserung der mechanischen Eigenschaften beschichtet sind.

Aus der EP 2 511 229 A1 sind mikromechanische Bauteile bekannt, die vollflächig mit einer Beschichtung aus Diamant oder diamantartigem Kohlenstoff beschichtet sind. Die hier beschriebenen Bauteile sind einstückig, d.h. monolithisch aufgebaut.

Gerade im Bereich mikromechanischer Bauteile und hier insbesondere bei mikromechanischen Uhrwerksbauteilen besteht ein starkes Bedürfnis nach sehr komplex aufgebauten Bauteilen, die häufig nicht aus monolithischen Bauteilen hergestellt werden können, da sie eine sehr komplexe Struktur oder ein ungünstiges Aspektverhältnis, (d.i. das Verhältnis aus der Tiefe bzw. der Höhe der Struktur zu ihrer lateralen Ausdehnung) besitzen. Hier bleibt dann gemäß dem Stand der Technik nur die Möglichkeit, verschiedene monolithische Bauteile mit besagten Beschichtung miteinander zu koppeln. Bisherige Techniken versagen aber dabei, eine Verbindung der monolithischen Bauteilkomponenten zu ermöglichen, die eine über einen längeren Zeitraum ausreichende mechanische Stabilität aufweist.

Die veröffentlichte Patentanmeldung CH 699 680 A2 offenbart mikromechanische Uhrwerksbauteile aus mehreren vorgefertigten modularen Bauteilkomponenten, die über Kontaktflächen in Verbindung stehen. Der mechanische Zusammenhalt der Komponenten erfolgt durch eine Presspassung. Die Möglichkeit einer Diamantbeschichtung einzelner Komponenten ist ebenfalls erwähnt.

Hiervon ausgehend war es Aufgabe der vorliegenden Erfindung, mikromechanische Bauteile bereitzustellen, die modular aufgebaut sind und dennoch eine hohe mechanische Stabilität aufweisen. Gleichzeitig sollen derartige Bauteile mit einer massenproduktionstauglichen Technologie herstellbar sein.

Diese Aufgabe wird durch das mikromechanische Bauteil mit den Merkmalen des Anspruchs 1 und das Verfahren zu dessen Herstellung mit den Merkmalen des Anspruchs 11 gelöst. Die weiteren abhängigen Ansprüche zeigen vorteilhafte Weiterbildungen auf. Erfindungsgemäße Verwendungen werden in Anspruch 14 angegeben.

Erfindungsgemäß wird ein mikromechanisches Uhrwerksbauteil aus mehreren modularen Bauteilkomponenten bereitgestellt, wobei jede Bauteilkomponente mit mindestens einer weiteren Bauteilkomponente über mindestens eine Kontaktfläche in Kontakt steht. Unter Kontaktfläche ist im Rahmen der vorliegenden Erfindung auch ein einzelner Kontaktpunkt oder die Aneinanderreihung mehrerer Kontaktpunkte ebenso wie eine Kontaktlinie zu verstehen.

Diese Bauteilkomponenten sind mittels einer zumindest bereichsweisen Beschichtung der Bauteiloberfläche formschlüssig verbunden. Diese Beschichtung ist **dadurch gekennzeichnet, dass** sie aus Diamant besteht oder dieses im wesentlichen enthält.

Eine bevorzugte Ausführungsform sieht vor, dass das gesamte Bauteil vollflächig mit der Beschichtung umgeben ist oder nur Bereiche des Bauteils beschichtet sind, um eine formschlüssige Verbindung der Bauteilkomponenten zu ermöglichen. Im ersten Fall wird dabei das gesamte Bauteil durch die Beschichtung eingeschlossen, wodurch eine Fixierung der Bauteilkomponenten zueinander erfolgt. Im zweiten Fall werden nur die Bereiche an der Oberfläche des Bauteils beschichtet, an denen einzelne Bauteilkomponenten aufeinanderstoßen. Die Größe der beschichteten Bereiche wird dabei so gewählt, dass eine formschlüssige Verbindung der Bauteilkomponenten gegeben ist und so das gesamte Bauteil mechanisch stabil ist. Die Beschichtung dient somit als formschlüssiges Verbindungselement für die einzelnen Bauteilkomponenten. Dies kann vorzugsweise dadurch realisiert werden, dass die Beschichtung die Oberfläche des Bauteils im Bereich der Kontaktflächen der Bauteilkomponenten abdeckt und so eine formschlüssige Verbindung der einzelnen Bauteilkomponenten ermöglicht.

Die aus Diamant bestehende oder dieses im wesentlichen enthaltende Beschichtung ist vorzugweise nanokristallin, kann aber auch mikrokristallin sein.

Bei der erfindungsgemäßen Beschichtung kann es sich ebenfalls um eine tribologische Beschichtung handeln, die zudem auch als Verschleißschutz eingesetzt werden kann.

Vorzugweise weist die erfindungsgemäße Beschichtung mindestens eine der folgenden Eigenschaft auf:
- eine Biegebruchspannung σ₀ von mindestens 2 GPa, bevorzugt mindestens 5 GPa und besonders bevorzugt mindestens 7 GPa,
- ein E-Modul von maximal 1000 GPA, bevorzugt maximal 700 GPa und besonders bevorzugt von maximal 500 GPa,
- eine Oberflächenrauigkeit von 3 bis 100 nm rms, bevorzugt von 4 bis 30 nm rms

Bezüglich der Definition der Biegebruchspannung wird auf die folgenden Literaturstellen verwiesen:
- R. Morrell et al., Int. Journal of Refractory Metals & Hard Materials, 28 (2010), S. 508-515;
- R. Danzer et al. in "Technische keramische Werkstoffe", herausgegeben von J. Kriegesmann, HvB Verlag, Ellerau, ISBN 978-3-938595-00-8, Kapitel 6.2.3.1- Der 4-Kugelversuch zur Ermittlung der biaxialen Biegefestigkeit spröder Werkstoffe".

Die Biegebruchspannung wird dabei durch statistische Auswertung von Bruchversuchen z.B. im B3B-Belastungsversuch gemäß den oben stehenden Literaturangaben ermittelt. Sie ist dabei definiert als die Bruchspannung, bei der eine Bruchwahrscheinlichkeit von 63 % vorliegt.

Die Bestimmung der Oberflächenrauhigkeit erfolgt mit einem Rasterkraftmikroskop (AFM), wobei das Arbeitsfeld, d.h. der gescannte Bereich, eine Größe von 50 x 50 µm besitzt.

Die Verwendung von nanokristallinen Diamantschichten mit möglichst kleiner mittlerer Korngröße führt dazu, dass das E-Modul gegenüber polykristallinen Diamantschichten deutlich erniedrigt wird, so dass eine bessere Anpassung der E-Module von Diamantschicht und Substrate gewährleistet ist. So weisen polykristalline Diamantschichten meist ein E-Modul von > 1000 GPa auf. Typische Substratmaterialien, wie beispielswiese Silizium oder Siliziumdioxid, besitzen einen deutlich geringeren E-Modul von etwa 100 bis 200 GPa. Der große Unterschied der Biegesteifigkeit zwischen Substrat und Beschichtung führt im mechanischen Belastungsfall zu einer starken Belastung des Kontaktbereichs, welches im schlimmsten Fall versagen kann und damit zu einer Delamination der Diamantschicht führen kann. Letzteres hat das Totalversagen des Bauteils zur Folge. Aus diesem Grund ist eine Angleichung der Biegesteifigkeit von Substrat und Beschichtung vorteilhaft. Dies kann durch eine Verringerung der Korngröße erreicht werden. Da mit abnehmender Korngröße der Diamantschicht das Korngrenzenvolumen im Verhältnis zum Kristallvolumen (Kornvolumen) zunimmt und an der Korngrenze in der Regel schwächere Bindungen als im Kristall (Korn) vorhanden sind, korreliert das makroskopisch ermittelte E-Modul diametral mit der mittleren Korngröße. Typische Werte für das E-Modul von nanokristallinen Diamantschichten (Korngröße etwa 10 nm) liegen im Bereich von < 900 GPa und ganz besonders bevorzugt < 700 GPa.

Erfindungsgemäß wird unter nanokristallinem Diamant eine Diamantschicht verstanden, wobei die kristallinen Domänen eine mittlere Korngröße d₅₀ von 1 bis 100 nm, bevorzugt ≤ 50 nm aufweisen. Hierunter wird verstanden, dass zumindest bei 50 % der Kristallite jede Dimension eines einzelnen Kristallite ≤ 100 nm (bevorzugt ≤ 50 nm) ist. Die fein-kristalline Diamantschicht zeichnet sich somit durch eine äußerst hohe Homogenität der Kristallite aus.

Weiter ist bevorzugt, wenn der in Richtung der Dicke der nanokristallinen Diamantschicht gemessene Gradient der mittleren Korngröße des nanokristallinen Diamants < 250 %, bevorzugt < 50 %, besonders bevorzugt < 20 % beträgt. Diese Ausführungsform sieht vor, dass der mittlere Korngrößendurchmesser der feinkristallinen Domänen der Diamantschicht durch die gesamte Schichtdicke hindurch relativ gleichmäßig bis besonders gleichmäßig verteilt ist, d.h. die Korngrößen sind auf der einen Seite der Diamantschicht ca. gleich groß wie auf der anderen Seite der Diamantschicht; besonders vorteilhaft ist dabei natürlich eine nahezu oder eine vollständig komplette Homogenität der feinkristallinen Domänen der Diamantschicht. Der Gradient wird dadurch bestimmt, dass der mittlere Korngrößendurchmesser d₅₀ auf einer Seite der Diamantschicht ermittelt wird und in Bezug zum mittleren Korngrößendurchmesser auf der gegenüber liegenden Seite der Diamantschicht in Bezug gesetzt wird.

Der, im Wesentlichen über das Korngrenzenvolumen bestimmte, Anteil von sp2 bzw. sp3 gebundenem Kohlenstoff in der Diamantschicht beträgt vorteilhafterweise zwischen 0,5 und 10 %, bevorzugt zwischen 2 und 9 %, besonders bevorzugt zwischen 3 und 8 % beträgt.

Weiterhin wirkt sich die Verwendung von Diamantschichten mit mittleren Korngrößen im Bereich zwischen 5 und 100 nm und besonders bevorzugt im Bereich zwischen 1 und 10 nm vorteilhaft auf die Oberflächenrauigkeit aus, da diese ebenfalls mit abnehmender Korngröße abnimmt. Der ermittelte Gleitreibkoeffizient (z.B. ermittelt durch rotativen Reibversuch Kugel gegen Scheibe mittels eines Tribometers) zweier in Kontakt stehender Diamantschichten hängt von dessen Oberflächenrauheiten ab. Können sich die mikroskopisch vorhandenen Rauhheiten miteinander verzahnen, wird makroskopisch ein erhöhter Gleitreibkoeefizient gemessen. Dieser liegt im Bereich von etwa 0,3. Nach einiger Zeit führt der Reibkontakt z einer Politur der Oberflächen, die im besten Fall zu einer ideal glatten Oberfläche führt. Ist dieser Zustand erreicht, werden Gleitreibkoeffizienten von 0,01 bis 0,03 gemessen. Der kleine Korndurchmesser nanokristalliner Diamantschichten wirkt sich deshalb auch direkt auf den Gleitreibkoeffizienten der Bauteile aus, sofern die Diamantschicht auch geleichzeitig als Tribologische Schicht, d.h. im berührungskontakt mit anderen beweglichen Bauteilen stehend, verwendet wird.

Selbstverständlich können die Oberflächen aus den Diamantschichten auch durch eine nachgelagerte Politur mechanisch nachbearbeitet werden, z.B. durch mechanisches Gleit- oder Schleppschleifen. Auch ein Ultraschallunterstütztes Schleifen in abrasiven Suspension aus Diamantpartikeln oder keramischen Schleifmitteln, wie z.B. Al₂O₃ oder SiC oder o.ä., Plasmapolitur in Sauerstoff und/oder Chlor- und/oder fluorhaltigen Plasmen und/oder lonenunterstützte Bearbeitungsschritte, wie RIE (reacitve ion etching), Ion Milling, oder andere lonenstrahl-unterstütze Verfahren sind möglich. Dadurch wird eine vorteilhafte Oberflächenrauigkeit zwischen 1 und 50 rms, besonders vorteilhaft eine Oberflächenrauigkeit 2 bis 7 nm rms erreicht.

Es ist weiter bevorzugt, dass die Beschichtung eine Schichtdicke im Bereich von 1 bis 100 µm, bevorzugt von 5 bis 50 µm und besonders bevorzugt von 10 bis 30 µm aufweist. Die Schichtdicke ist notwendig, um einen sicheren Übergang (Zusammenwachsen) der Schicht auf den beiden Bauteilkomponenten zu gewährleisten. Hierbei gilt tendenziell je dicker umso fester ist der Zusammenhalt.

Bei der erfindungsgemäßen Beschichtung handelt es sich vorzugsweise um eine isotrop gewachsene Beschichtung. Hierunter ist eine der Struktur folgende Beschichtung zu verstehen, die möglichst keinerlei Überhöhungen aufweist.

Eine weitere erfindungsgemäße Ausführungsform sieht vor, dass die Beschichtung, die aus Diamant besteht oder dieses im Wesentlichen enthält, dotiert ist. Bevorzugte Dotierstoffe sind hier Bor, Stickstoff und/oder Ammoniak. Der Dotierstoff wird hierbei gasförmig während der Beschichtung zugegeben.

Die Art der Dotierung kann n- oder p-Typ sein.

Hinsichtlich der dotierten Beschichtungen ist es ein wichtiger Vorteil, dass hierdurch ein, bezüglich der elektrischen eigenschaften, metallähnlicher Charakter der erfindungsgemäßen Beschichtung insbesondere durch hohe Dotierstoffkonzentration von mindestens 10¹⁹ cm ⁻³, besonders bevorzugt mindestens 10²⁰ ccm⁻³ erreicht werden kann. Die hohe Dotierstoffkonzentration soll sicherstellen dass der Material/ diamantkontakt möglichst keine Sperreigenschaften (siehe Schottkykontakt) aufweist, möglichst Barrierefrei ist und Ladungsträger (je nach Dotierung n oder p) das Interface möglichst Barrierefrei durchdringen könne. Hierdurch wird es möglich, dass einzelne Bauteilkomponenten miteinander elektrisch leitend (über die Beschichtung) verbunden werden können. Eine weitere Variante sieht vor, dass die derartig dotierte Beschichtung das gesamte Bauteil einschließt und somit einen Faradayschen Käfig darstellt, der dann als elektrische Abschirmung für das Bauteil dienen kann.

Die o.g. Maßnahmen vermeiden das Auftreten von elektrostatischen oder elektrodynamischen Effekten, welche zu einer Aufladung der Bauteile oder einzelner Bauteilkomponenten führen können.

Zum verfahren der Dotierung wird auch auf folgende Literatur verwiesen:
Low-Pressure Synthetic Diamond: Manufacturing and Applications (Springer Series in Materials Processing) Eds. B. Dischler
Verlag: Springer; Auflage: 1 (17. September 1998)
Sprache: Englisch
ISBN-10: 3540636196
ISBN-13: 978-3540636199
Eine weitere bevorzugte Ausführungsform sieht vor, dass die Bauteilkomponenten unabhängig voneinander aus Materialien bestehen oder diese im Wesentlichen enthalten, die ausgewählt sind aus der Gruppe bestehend aus
   a) Halbmetallen, bevorzugt Kohlenstoff, Silizium oder Germanium;
   b) metallischen Materialien, bevorzugt Fe, Ni, Cr, Co, Cu, Mn, V, Ti, Sc, W, Ta, Mo, Nb, Pt, Au, Rh;
   c) Legierungen aus den unter b) genannten metallischen Materialien;
   d) metallischen Karbiden der refraktären Metalle Ti, Ta, W, Mo, Ni;
   e) eisenhaltigen Werkstoffen, wie Stahl;
   f) Verbundwerkstoffen aus keramischen Werkstoffen in einer metallischen Matrix (Cermets), Hartmetallen, gesinterten Carbidhartmetallen, wie z.B. Cobalt oder Nickel-gebundenen Wolframkarbiden oder Titankarbiden;
   g) kohlenstoff- und/oder stickstoff- und/oder bor- und oder sauerstoffhaltigen keramischen Werkstoffen, wie z.B. Siliziumkarbid, Siliziumnitrid, Bornitrid, Titannitriden, AlN, CrN, TiAlN, TiCN, und/oder TiB₂, Glaskeramiken, insbesondere Aluminiumsilikat-Glaskeramiken, bevorzugt ausgewählt aus der Gruppe bestehend aus Zerodur, Zerodur M und/oder Zerodur K20 Saphir;
   h) Kohlenstoff, wie z.B. Graphit, einkristalliner Diamant, polykristalliner Diamant, nanokristalliner Diamant und
   i) Kombinationen von den Materialien a) bis h).

Das mikromechanische Bauteil ist ein Uhrwerksbauteil, das bevorzugt ausgewählt ist aus der Gruppe bestehend aus Zugfedern, Ankern, Ankerrädern, Hemmbauteilen, Plateaus, Zahnrädern, Trieben, Lagersteinen, Decksteinen, Lagerzapfen, Wellen, Achsen, Federn, Zugfedern, Unruhfedern, Unruhen und Kombinationen hiervon, z.B. ein Zahnrad mit Achse sowie Platinenteilen, Kloben und Brücken

Erfindungsgemäß wird ebenso ein Verfahren zur Herstellung des zuvor beschriebenen mikromechanischen Bauteils bereitgestellt, das folgende Schritte aufweist:
a) Formschlüssiges und/oder kraftschlüssiges Fügen der Bauteilkomponenten, wobei jede Bauteilkomponente mit mindestens einer weiteren Bauteilkomponente über mindestens eine Kontaktfläche in Kontakt gebracht wird,
b) Vollflächige oder bereichsweise Nukleation der Bauteiloberfläche mit kohlenstoffhaltigen Edukten zur Bildung von Diamantkeimen, und
c) Aufwachsen des Diamants mittels einer CVD-Abscheidung.

Erfindungsgemäß ist es möglich, dass in einem sich anschließenden Schritt d) die Diamantbeschichtung durch Plasmaätzen oder Veraschen teilweise oder vollflächig entfernt wird.

Eine weitere bevorzugte Ausführungsform sieht vor, dass vor Schritt a) eine Vorbehandlung der Bauteilkomponenten erfolgt. Diese kann zum einen darin bestehen, dass mittels chemischen Ätzens die Oberflächenrauheit der Bauteilkomponenten erhöht wird. Als Beispiel ist hier das Aufrauen von Hartmetall durch chemisches Ätzen zu nennen, bei dem das Kobalt aus dem Hartmetall gelöst wird und die Oberflächenrauigkeit dadurch erhöht wird. Ebenso ist es möglich, dass ein mechanisches Anrauen der Oberflächen erfolgt. Eine weitere wichtige Möglichkeit, die Haftung zwischen den Bauteilkomponenten und der Diamantbeschichtung zu verbessern besteht darin, ein definiertes Interface zwischen der Diamantbeschichtung und dem Material der Bauteilkomponenten bereitzustellen. Dies kann z.B. für den Fall einer Bauteilkomponente aus Silicium, eine Zwischenschicht aus Siliciumcarbid sein. Dies kann u.a. insitu während des CVD-Beschichtungsprozesses durch eine Temperaturerhöhung auf über 750 °C direkt im Beschichtungsprozess gebildet werden. Die Zwischenschicht erhöht die Stabiliät des Interfaces zwischen der Diamantschicht und Bauteiloberfläche, da die Kohlenstoffatome der Diamantschicht zumindest teilweise chemisch mit dem Bauteilwerkstoff verbunden sind.

Mit dem erfindungsgemäßen Verfahren ist es möglich, beliebige Bauteilkomponenten miteinander zu verbinden. Ein Beispiel hierfür ist, dass eine Bauteilkomponente ein Zahnrad mit einer elastischen Achsaufnahme und ein zweites Bauteil einer Achse ist. Hierbei wird zunächst die Achse in der Achsaufnahme arretiert und anschließend erfolgt das Aufwachsen der Beschichtung zumindest im Kontaktbereich zwischen Zahnrad und Achse, sodass ein mechanisches Bauteil aus Zahnrad mit zugehöriger Achse resultiert. Es ist aber ebenso möglich, eine vollflächige Beschichtung des Gesamtbauteils vorzunehmen.

Eine bevorzugte Ausführungsform des erfindungsgemäßen Verfahrens sieht vor, dass die Herstellung der Bauteile in Wafer-Technologie erfolgt. Hierbei wird auf einem ersten Wafer eine Vielzahl von ersten Bauteilkomponenten mittels Ätzung erzeugt. Ebenso wird auf einem zweiten Wafer eine Vielzahl von zweiten Bauteilkomponenten durch Ätzen hergestellt. Im Anschluss werden dann die beiden Wafer so zueinander positioniert, dass die ersten und zweiten Bauteilkomponenten jeweils zueinander in den gewünschten Kontakt treten können. Die so positionierten Wafer werden anschließend nukleiert und dann in die CVD-Beschichtungsanlage eingebracht, wo dann das Aufwachsen der Diamantbeschichtung erfolgt. Abschließend werden dann die aus den formschlüssig verbundenen Bauteilkomponenten bestehenden Bauteile von den Wafern gelöst.

Verwendung finden die erfindungsgemäßen mikromechanischen Bauteile als Uhrwerksbauteile, insbesondere als Zugfedern, Ankern, Ankerrädern, Hemmbauteilen, Plateaus, Zahnrädern, Trieben, Lagersteinen, Decksteinen, Lagerzapfen, Wellen, Achsen, Federn, Zugfedern, Unruhfedern, Unruhen, Zeiger, Indexe, Ziffernblätter, Platinteile, Kloben, Brücken, Stoßsicherungen und Kombinationen hiervon.

Anhand des nachfolgenden Beispiels und der nachfolgenden Figuren soll der erfindungsgemäße Gegenstand näher erläutert werden, ohne diesen auf die hier gezeigten spezifischen Ausführungsformen einschränken zu wollen.

### Beispiel

Die feinkristallinen Diamantschichten werden z.B. mittels eines "Heißdraht-CVD-Verfahrens" hergestellt. Bei diesem Verfahren wird in einer Vakuumkammer mittels heißer Drähte, z.B. Wolframdrähte, eine Gasphase bestehend aus z.B. 1 bis 5 Vol.-% CH₄ und 95 bis 99 Vol.-% Wasserstoff aktiviert. Die Drahttemperatur liegt beispielsweise in einem Bereich von 1.800°C bis 2.400°C. Bei einem Abstand zwischen dem Substrat und den Drähten von 1 cm bis 5 cm wird dabei eine Substrattemperatur von 600 °C bis 900 °C eingestellt. Der Druck der Gasatmosphäre liegt zwischen 3 mbar und 30 mbar. Dabei erfolgt eine Abscheidung der nanokristallinen Diamantschicht auf dem Substrat.

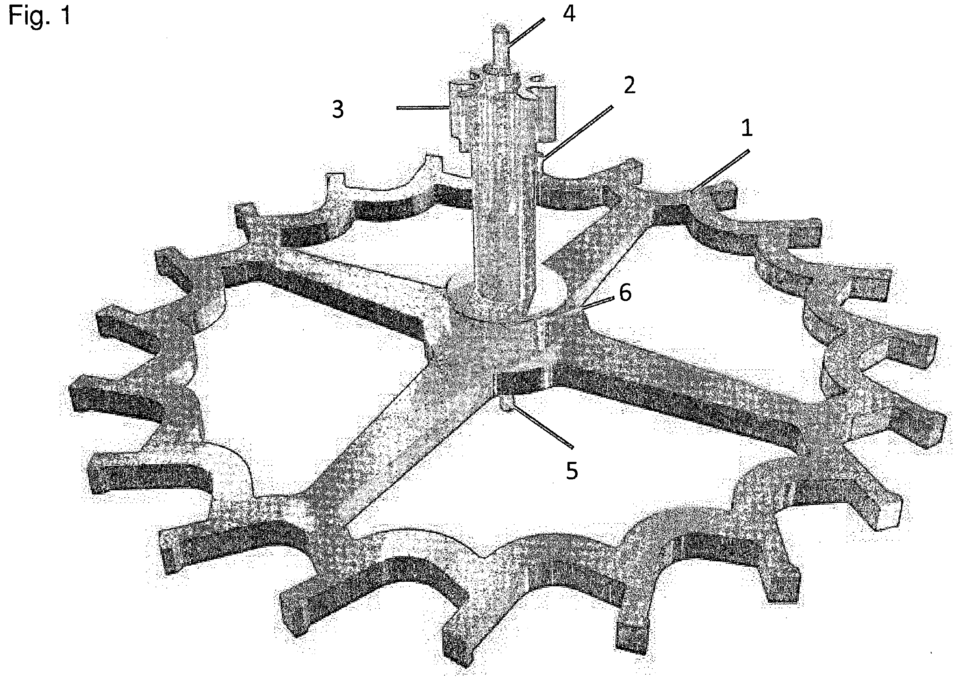

Fig. 1 zeigt ein erfindungsgemäßes mikromechanisches Bauteil, das aus zwei Komponenten aufgebaut ist. Die erste Bauteilkomponente stellt in diesem Fall ein Ankerrad dar, das z.B. aus Silizium gefertigt ist. Die zweite Bauteilkomponente stellt eine Achse 2 dar, die zusätzlich einen Trieb (Ritzel) 3 sowie Lagerzapfen 4 und 5 aufweist. Die Achse 2 wird nun über ein Plateau 6 zur Auflage des Ankerrades 1 in Kontakt gebracht. Im Anschluss erfolgt dann die Nukleation der Bauteiloberfläche gefolgt vom Aufwachsen des Diamants mittels CVD-Beschichtung.

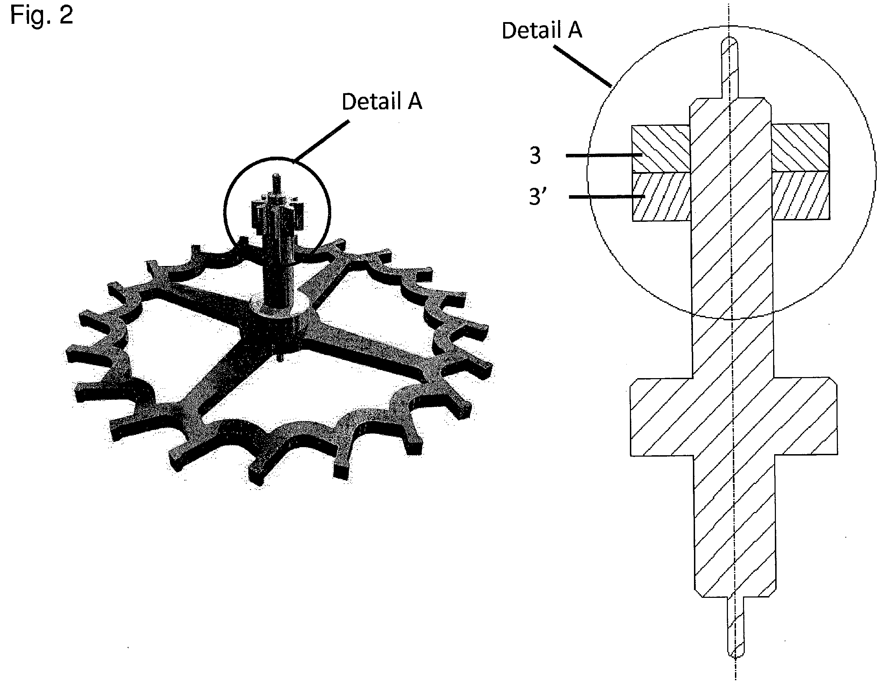

Fig. 2 zeigt in einer Vergrößerung das Detail a) der Fig. 1, d.h. den Trieben 3 und 3' an der Achse 2. Die Triebe 3 und 3' sind hier identisch in ihrer Geometrie. Sie werden übereinander gelegt und anschließend mit der Diamantbeschichtung verbunden, damit das eingreifende Rad mit genügend Überlapp in den Trieb eingreifen kann. Da die Herstellung von Bauteilen mit hohem Aspektverhältnis, d.h. Bauteilen, deren vertikale Ausdehnung deutlich größer als die laterale Ausdehnung ist, mit Ätzverfahren nur schwer (aufgrund mangelnder Vertikalität und Oberflächengüte der Seitenflanke beim Ätzprozess) zu realisieren sind, werden gemäß der vorliegenden Figur zwei Triebe kleinerer Stärke hergestellt und superpositioniert. Sofern dies erforderlich ist, kann die Zahl der Triebe auch weiter erhöht werden.

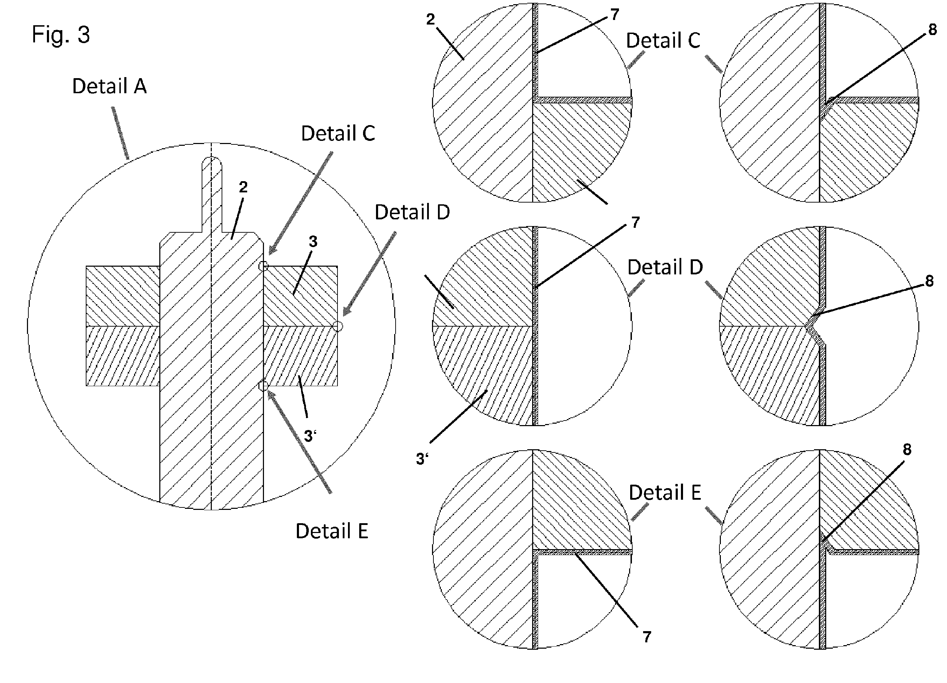

In Fig. 3 ist anhand einer Schnittdarstellung das Detail a) aus Figur 1 mit der Achse 2 und den Trieben 3 und 3' dargestellt. Die hier gezeigten Details c), d) und e) zeigen die Kontaktbereiche zwischen den Bauteilkomponenten an dem die formschlüssige Verbindung mittels der Diamantbeschichtung erfolgt. Die Superpositionierung ist dabei insofern kritisch, dass die beiden Bauteilkomponenten exakt zueinander ausgerichtet sein müssen. Dies kann z.B. dadurch sichergestellt werden, dass Strukturen verwendet werden, die nach dem Prinzip von Legosteinen ineinander greifen, d.h. eine Bauteilkomponente weist einen Zapfen auf, der formschlüssig in ein passendes Loch (ggf. auch eine elastische Zapfenaufnahme) der weiteren Bauteilkomponente eingefügt wird. Hierdurch wird auch sichergestellt, dass die Bauteile planparallel aufeinander liegen und ein gegebenenfalls auftretender Spannungsverzug des/der Wafer (und damit des/der Bauteil(e)) korrigiert werden kann. Weiterhin kann es von Vorteil sein, an den Kontaktbereichen zwischen den Bauteilkomponenten Fasen 8 anzubringen, sodass der Kontaktbereich der beiden Bauteilkomponenten möglichst wenig belastet wird.

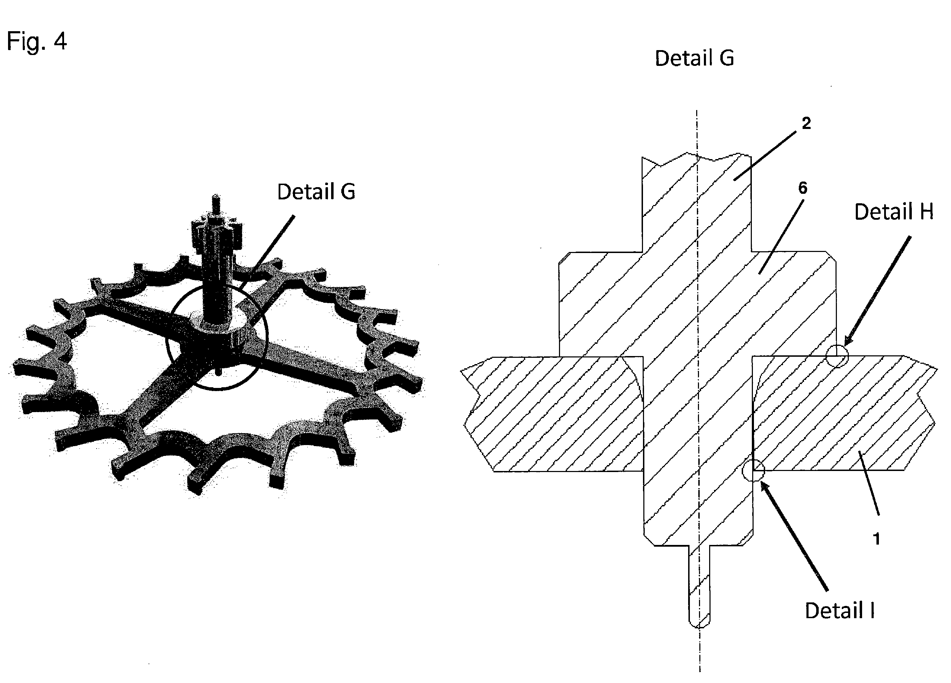

In Fig. 4 ist das Detail g) der Fig. 1 dargestellt. Hierbei ist die Achse 2 in die Achsaufnahme des Ankerrades 1 eingefügt, wobei durch das Plateau 6 die Position der Achse 2 festgelegt wird.

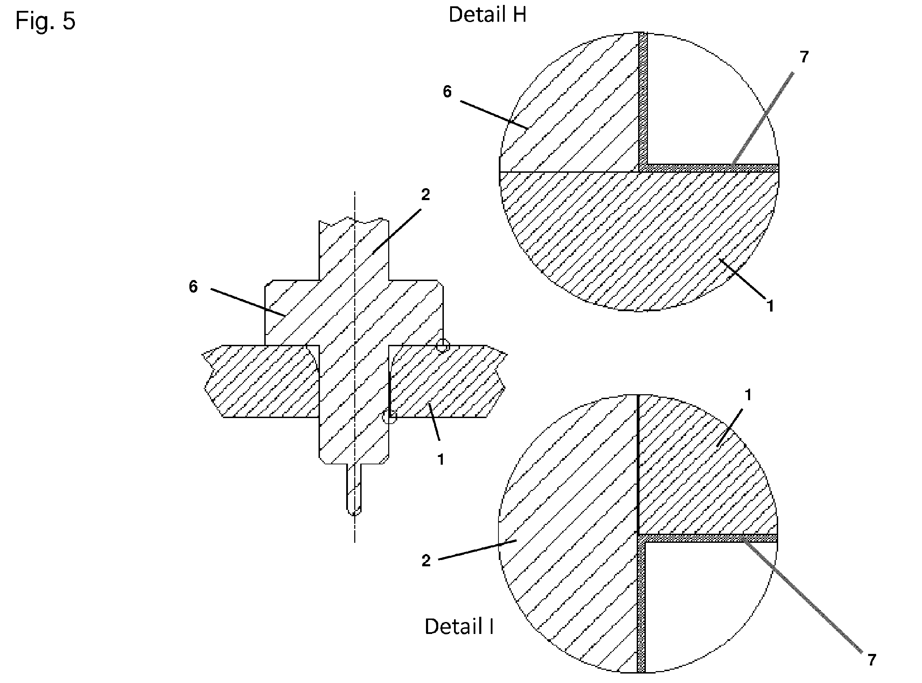

In Fig. 5 ist die formschlüssige Verbindung des Ankerrades 1 mit der Achse 2 dargestellt. Im Bereich der Kontaktfläche des Plateaus 6 mit dem Ankerrad 1 ist die formschlüssige Verbindung über die Diamantschicht 7 realisiert. Ebenso ist im Kontaktbereich der Achse 2 mit dem Ankerrad 1 an der Bauteiloberfläche die Diamantschicht 7 abgeschieden.

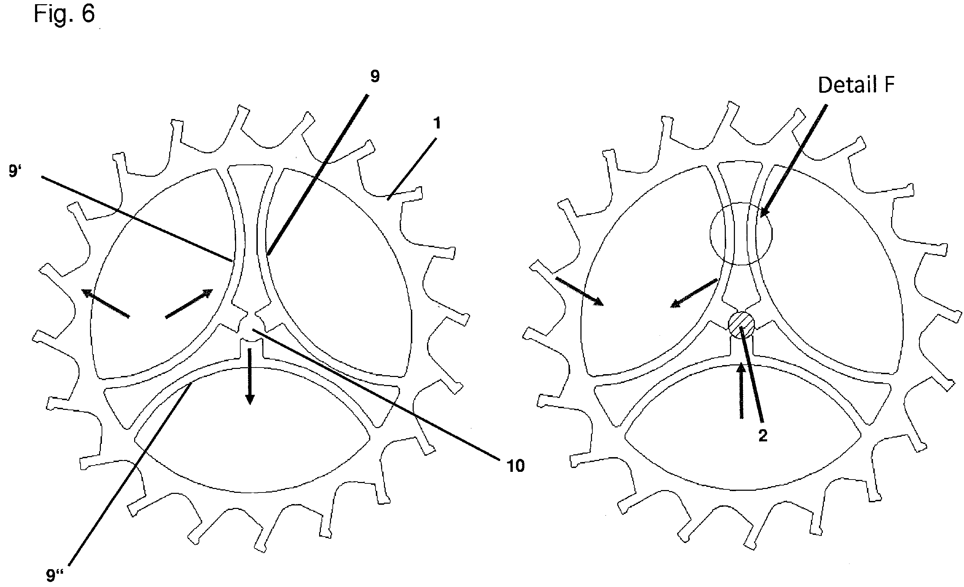

In Fig. 6 ist ein Ankerrad 1 mit elastischen Armen 9, 9' und 9" dargestellt. Das Prinzip der elastischen Achsaufnahmen basiert darauf, dass die drei elastischen Arme 9, 9' und 9" beim Einführen der Achse im Zentrum gespreizt werden, da die Dimensionierung der Achse etwas größer ist als die der Achsaufnahme 10. Dieses Einführen der Achse 2 kann mit Hilfe eines Werkzeugs oder direkt durch Einschieben der Achse 2 in die Achsaufnahme 10 erfolgen. Für das direkte Einschieben der Achse ist es erforderlich, dass sowohl die Achsaufnahme 10 als auch die Achse 2 über entsprechende Fasen verfügen, die dafür sorgen, dass die Bauteilkomponenten zueinander den Weg finden. Anschließend wird das Ankerrad 1 durch die drei elastischen Arme 9, 9' und 9" an die Achse 2 angepresst und damit justiert. In diesem Zustand währe das Ankerrad 1 nicht funktionstüchtig, da einerseits das Ankerrad 1 immer noch elastisch mit der Achse 2 verbunden ist und andererseits die Position der Achsaufnahme 10 relativ zur Achse 2 nicht gegen Verschiebung fixiert ist.

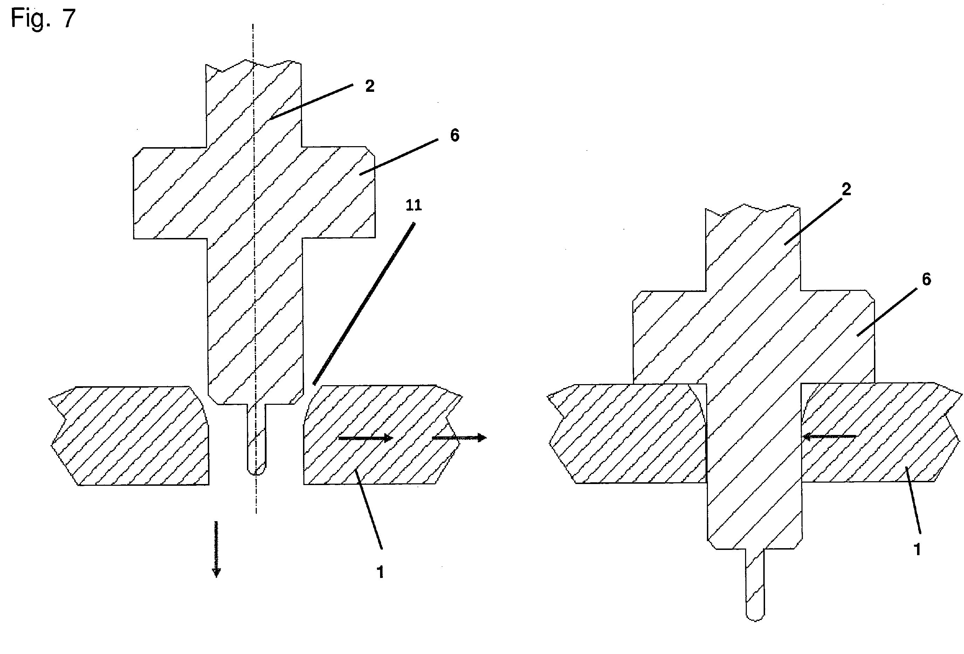

In Fig. 7 ist im Detail die Anbringung von Fasen 11 am Ankerrad 1 zur besseren Zusammenführung des Ankerrades 1 mit der Achse 2 dargestellt.

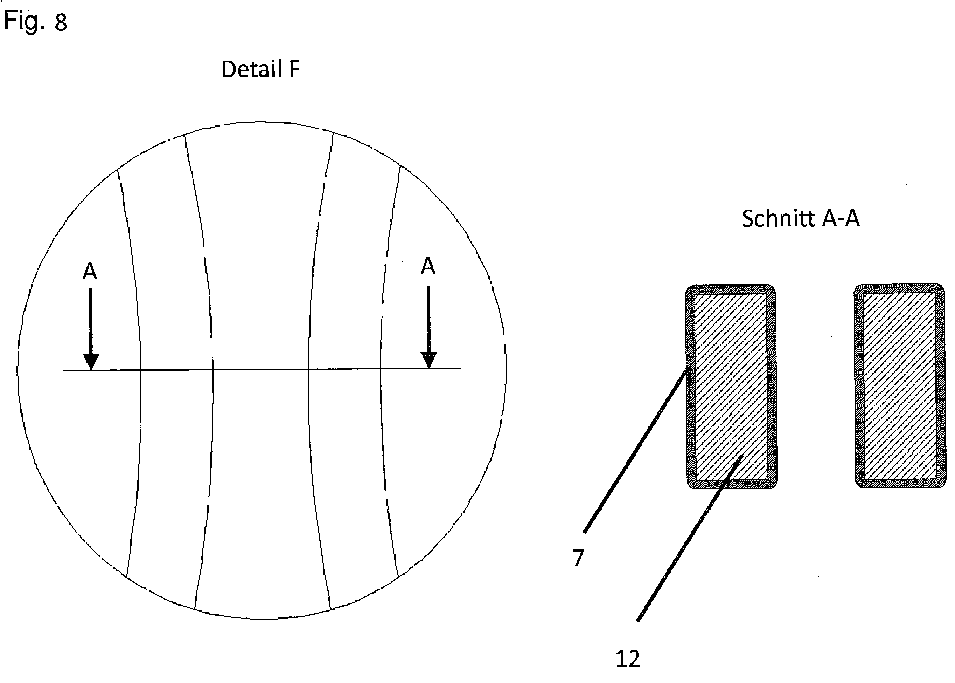

In Fig. 8 ist das Detail f) aus Fig. 6 dargestellt. Durch die Diamantbeschichtung 7 wird die Biegesteifigkeit so erhöht, dass die Arme 9, 9' und 9" ihre federnde Wirkung verlieren.

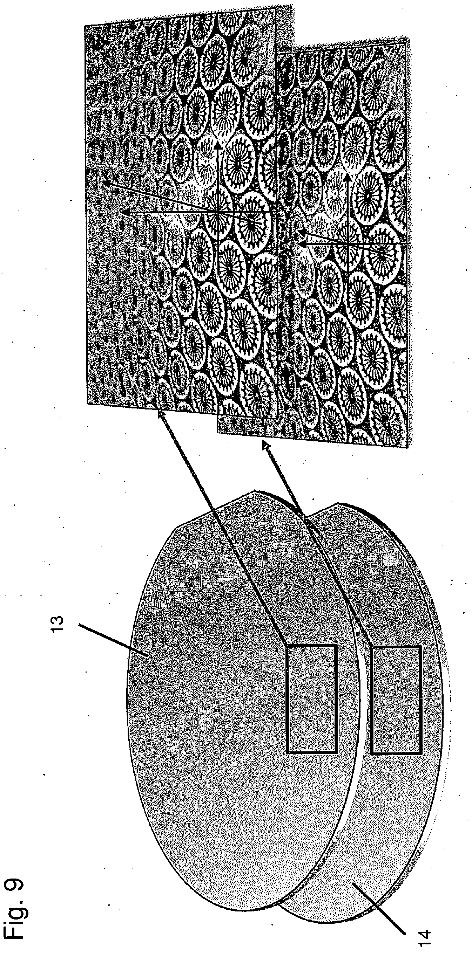

In Fig. 9 ist schematisch die Wafertechnologie beschrieben, die eine besonders bevorzugte Herstellungsweise für die mikromechanischen Bauteile darstellt. Hierbei werden zunächst zwei Wafer hergestellt und strukturiert. Dies kann mit identischen Masken oder verschiedenen Maskenlayouts geschehen. Wichtig ist lediglich, dass die Position der Bauteilkomponenten auf den Masken relativ zueinander korrekt ist. Die Bauteile werden jeweils mittels kleiner Brücken auf dem Wafer fixiert. Somit müssen keine Einzelbauteile manipuliert werden, sondern der ganze Wafer mit einer Vielzahl von Bauteilkomponenten. Anschließend werden mehrere Wafer superpositioniert. Hierzu muss die Lage der Bauteilkomponenten auf den beiden Wafern zueinander justiert werden. Dies geschieht unter dem Mikroskop durch Verschieben eines Wafers relativ zum anderen. Sobald die Justage erfolgt ist, wird die Position der beiden Wafer fixiert, was durch ein Klemmwerkzeug oder bevorzugt durch kleine elastische Aufnahmen, z.B. in Form von Löchern und Zapfen, die zuvor auf beiden Wafern implementiert wurden, erfolgen kann. Beispielsweise kann der Wafer 13 eine Noppe aufweisen, während der Wafer 14 einen elastischen Clip zur Aufnahme der Noppe besitzt. Anschließend erfolgt die Nukleation und Beschichtung. Die so entstandenen mehrstufigen Bauteile können anschließend ausgebrochen werden oder es erfolgt ein weiterer Aufbauschritt.

## Patentansprüche

1. Mikromechanisches Uhrwerksbauteil aus mehreren vorgefertigten modularen Bauteilkomponenten (1,2,3,3',6), wobei jede Bauteilkomponente mit mindestens einer weiteren Bauteilkomponente über mindestens eine Kontaktfläche in Kontakt steht **dadurch gekennzeichnet, dass** die Bauteilkomponenten mittels einer zumindest bereichsweisen Beschichtung (7) der Bauteiloberfläche formschlüssig verbunden sind und die Beschichtung aus Diamant besteht oder im Wesentlichen enthält.

2. Mikromechanisches Bauteil nach Anspruch 1, **dadurch gekennzeichnet, dass** das gesamte Bauteil vollflächig mit der Beschichtung (7) umgeben ist oder nur Bereiche des Bauteils beschichtet sind, um eine formschlüssige Verbindung der Bauteilkomponenten (1,2,3,3',6) zu ermöglichen.

3. Mikromechanisches Bauteil nach einem der vorhergehenden Ansprüche, **dadurch gekennzeichnet, dass** die Beschichtung (7) als formschlüssigen Verbindungselement für die Bauteilkomponenten (1,2,3,3',6) fungiert.

4. Mikromechanisches Bauteil nach einem der vorhergehenden Ansprüche, **dadurch gekennzeichnet, dass** die Beschichtung (7) die Oberfläche des Bauteils im Bereich der Kontaktflächen der Bauteilkomponenten (1,2,3,3',6) abdeckt und so eine formschlüssige Verbindung der Bauteilkomponenten ermöglicht.

5. Mikromechanisches Bauteil nach einem der vorhergehenden Ansprüche, **dadurch gekennzeichnet, dass** die Beschichtung (7) mikrokristallin oder nanokristallin ist.

6. Mikromechanisches Bauteil nach einem der vorhergehenden Ansprüche, **dadurch gekennzeichnet, dass** die Beschichtung (7) dotiert ist, insbesondere mit Bor, Stickstoff und/oder Ammoniak.

7. Mikromechanisches Bauteil nach einem der vorhergehenden Ansprüche, **dadurch gekennzeichnet, dass** die Beschichtung (7) mindestens eine der folgenden Eigenschaften erfüllt:
- eine Biegebruchspannung σ₀ von mindestens 2 GPa, bevorzugt mindestens 5 GPa und besonders bevorzugt mindestens 7 GPa,
- ein E-Modul von maximal 1000 GPA, bevorzugt maximal 700 GPa und besonders bevorzugt von maximal 500 GPa,
- eine Oberflächenrauigkeit von 3 bis 100 nm rms, bevorzugt von 4 bis 30 nm rms.

8. Mikromechanisches Bauteil nach einem der vorhergehenden Ansprüche, **dadurch gekennzeichnet, dass** die Beschichtung (7) eine Schichtdicke im Bereich von 1 bis 100 µm, bevorzugt von 5 bis 50 µm und besonders bevorzugt von 10 bis 30 µm aufweist und vorzugsweise eine isotrop gewachsene Beschichtung ist.

9. Mikromechanisches Bauteil nach einem der vorhergehenden Ansprüche, **dadurch gekennzeichnet, dass** die Bauteilkomponenten (1,2,3,3',6) unabhängig voneinander aus Materialien bestehen oder diese im Wesentlichen enthalten, die ausgewählt sind aus der Gruppe bestehend aus
a) Halbmetallen, bevorzugt Kohlenstoff, Silizium oder Germanium;
b) metallischen Materialien, bevorzugt Fe, Ni, Cr, Co, Cu, Mn, V, Ti, Sc, W, Ta, Mo, Nb, Pt, Au, Rh;
c) Legierungen aus den unter b) genannten metallischen Materialien;
d) metallischen Karbiden der refraktären Metalle Ti, Ta, W, Mo, Ni;
e) eisenhaltigen Werkstoffen, wie Stahl;
f) Verbundwerkstoffen aus keramischen Werkstoffen in einer metallischen Matrix (Cermets), Hartmetallen, gesinterten Carbidhartmetallen, wie z.B. Cobalt oder Nickel-gebundenen Wolframkarbiden oder Titankarbiden;
g) kohlenstoff- und/oder stickstoff- und/oder bor- und oder sauerstoffhaltigen keramischen Werkstoffen, wie z.B. Siliziumkarbid, Siliziumnitrid, Bornitrid, Titannitriden, AIN, CrN, TiAlN, TiCN, und/oder TiB₂, Glaskeramiken, insbesondere Aluminiumsilikat-Glaskeramiken, bevorzugt ausgewählt aus der Gruppe bestehend aus Zerodur, Zerodur M und/oder Zerodur K20 Saphir;
h) Kohlenstoff, wie z.B. Graphit, einkristalliner Diamant, polykristalliner Diamant, nanokristalliner Diamant und
i) Kombinationen von den Materialien a) bis h).

10. Mikromechanisches Bauteil nach einem der vorhergehenden Ansprüche, **dadurch gekennzeichnet, dass** das mikromechanische Uhrwerksbauteil ausgewählt ist aus der Gruppe bestehend aus Zugfedern, Ankern, Ankerrädern, Hemmbauteilen, Plateaus, Zahnrädern, Trieben, Lagersteinen, Decksteinen, Lagerzapfen, Wellen, Achsen, Federn, Zugfedern, Unruhfedern, Unruhen und Kombinationen hiervon, z.B. ein Zahnrad mit Achse.

11. Verfahren zur Herstellung eines mikromechanischen Uhrwerksbauteils nach mindestens einem der vorhergehenden Ansprüche mit folgenden Schritten:
a) Formschlüssiges und/oder kraftschlüssiges Fügen der Bauteilkomponenten (1,2,3,3',6), wobei jede Bauteilkomponente mit mindestens einer weiteren Bauteilkomponente über mindestens eine Kontaktfläche in Kontakt gebracht wird,
b) Vollflächige oder bereichsweise Nukleation der Bauteiloberfläche mit kohlenstoffhaltigen Edukten zur Bildung von Diamantkeimen, und
c) Aufwachsen des Diamants (7) mittels einer CVD-Abscheidung.

12. Verfahren nach einem der Ansprüche 11,
**dadurch gekennzeichnet, dass** eine Bauteilkomponente ein Zahnrad (1) mit einer elastischen Achsaufnahme (10) und ein zweites Bauteil eine Achse (2) ist, wobei zunächst die Achse in der Achsaufnahme arretiert wird und anschließend durch das Aufwachsen der Beschichtung (7) eine mechanisch stabile Fixierung zwischen Achse (2) und Lager (10) erfolgt.

13. Verfahren nach einem der Ansprüche 11 oder 12, **dadurch gekennzeichnet, dass** die Herstellung in Wafertechnologie erfolgt, wobei vor Schritt a) auf einem ersten Wafer (13) eine Vielzahl von ersten Bauteilkomponenten (1,2,3,3',6) und auf einem zweiten Wafer (14) eine Vielzahl von zweiten Bauteilkomponenten (1,2,3,3',6) geätzt und anschließend auf Wafer-Basis verbunden wird.

14. Verwendung der mikromechanischen Bauteile nach einem der Ansprüche 1 bis 11 als Zugfedern, Ankern, Ankerrädern, Hemmbauteilen, Plateaus, Zahnrädern, Trieben, Lagersteinen, Decksteinen, Lagerzapfen, Wellen, Achsen, Federn, Zugfedern, Unruhfedern, Unruhen, Zeiger, Indexe, Ziffernblätter, Platinenteile und Kombinationen hiervon.

## Claims

1. Micromechanical clockwork component made from several prefabricated, modular structural components (1, 2, 3, 3', 6), wherein each structural component (1, 2, 3, 3', 6) comes into contact with at least one further structural component via at least one contact face, **characterised in that** the structural components are connected positively by means of an at least regional coating (7) of the component surface and the coating consists of, or substantially contains, diamond.

2. Micromechanical component according to claim 1, **characterised in that** the entire component is fully enclosed by the coating (7) or only regions of the component are coated, in order to enable a positive connection of the structural components (1, 2, 3, 3', 6).

3. Micromechanical component according to one of the preceding claims, **characterised in that** the coating (7) functions as a positive connecting element for the structural components (1, 2, 3, 3', 6).

4. Micromechanical component according to one of the preceding claims, **characterised in that** the coating (7) covers the surface of the component in the region of the contact faces of the structural components (1, 2, 3, 3', 6) and thus enables a positive connection of the structural components.

5. Micromechanical component according to one of the preceding claims, **characterised in that** the coating (7) is microcrystalline or nanocrystalline.

6. Micromechanical component according to one of the preceding claims, **characterised in that** the coating (7) is doped, in particular with boron, nitrogen and/or ammonia.

7. Micromechanical component according to one of the preceding claims, **characterised in that** the coating (7) complies with at least one of the following properties:
- a bending tensile strength σ₀ of at least 2GPa, preferably at least 5GPa and particularly preferably at least 7GPa,
- an elasticity modulus of maximum 1000GPa, preferably maximum 700GPa and particularly preferably maximum 500GPa,
- a surface roughness of 3 to 100nm rms, preferably 4 to 30nm rms.

8. Micromechanical component according to one of the preceding claims, **characterised in that** the coating (7) has a layer thickness ranging from 1 to 100µm, preferably from 5 to 50µm and particularly preferably from 10 to 30µm and is preferably an isotropically grown coating.

9. Micromechanical component according to one of the preceding claims, **characterised in that** the structural components (1, 2, 3, 3', 6) independently consist of, or substantially contain, materials selected from the group consisting of
a) metalloids, preferably carbon, silicon or germanium;
b) metallic materials, preferably Fe, Ni, Cr, Co, Cu, Mn, V, Ti, Sc, W, Ta, Mo, Nb, Pt, Au, Rh;
c) alloys of the metallic materials cited under b);
d) metallic carbides of the refractive metals Ti, Ta, W, Mo, Ni;
e) ferrous materials such as steel;
f) composite materials made from ceramic materials in a metallic matrix (cermets), hard metals, sintered carbide metals such as cobalt or nickel-bonded tungsten carbides or titanium carbides;
g) ceramic materials containing carbon and/or nitrogen and/or boron and/or oxygen, such as silicon carbine, silicon nitride, boron nitride, titanium nitride, AlN, CrN, TiAlN, TiCN and/or TiB₂, glass ceramics, in particular aluminium silicate glass ceramics, preferably selected from the group consisting of Zerodur, Zerodur M and/or Zerodur K20 Saphir;
h) carbon, such as graphite, monocrystalline diamond, polycrystalline diamond, nanocrystalline diamond, and
i) combinations of materials a) to h).

10. Micromechanical component according to one of the preceding claims, **characterised in that** the micromechanical clockwork component is selected from the group consisting of tension springs, armatures, escape wheels, impedance components, plateaus, gears, pinions, bearing jewels, end stones, bearing pins, shafts, axles, springs, tension springs, balance springs, balance wheels and combinations thereof, e.g. a gear with an axle.

11. Method for the production of a micromechanical clockwork component according to at least one of the preceding claims, having the following steps:
a) positive and/or negative joining of the structural components (1, 2, 3, 3', 6), wherein each structural component is brought into contact with at least one further structural component via at least one contact face,
b) full or regional nucleation of the component surface with carbonaceous reactants for the formation of diamond seed crystals, and
c) growing the diamond (7) by means of CVD deposition.

12. Method according to claim 11,
**characterised in that** a structural component is a gear (1) having an elastic shaft mount (10) and a second component is an axle (2), wherein, firstly, the axle is arrested in the shaft mount and there then takes place, by growing the coating (7), a mechanically stable fixing between the axle (2) and the bearing (10).

13. Method according to one of claims 11 or 12, **characterised in that** the production takes place with wafer technology, wherein, before step a), a plurality of first structural components (1, 2, 3, 3', 6) are etched on a first wafer (13) and a plurality of second structural components (1, 2, 3, 3', 6) are etched on a second wafer (14) and are then connected on a wafer base.

14. Use of the micromechanical components according to one of claims 1 to 11 as tension springs, armatures, escape wheels, impedance components, plateaus, gears, pinions, bearing jewels, end stones, bearing pins, shafts, axles, springs, tension springs, balance springs, balance wheels, pointers, indices, clock dials, board parts and combinations thereof.

## Revendications

1. Pièce micromécanique de mouvement d'horlogerie constituée de plusieurs composants modulaires préfabriqués (1, 2, 3, 3', 6), chaque composant de la pièce étant en contact avec au moins un autre composant par l'intermédiaire d'au moins une surface de contact, **caractérisée en ce que** les composants sont assemblés, par l'intermédiaire d'un revêtement (7) au moins par zones de la surface de la pièce, par liaison de forme, et que le revêtement est constitué de diamant ou en contient pour l'essentiel.

2. Pièce micromécanique selon la revendication 1, **caractérisée en ce que** la pièce dans son ensemble est entourée en pleine surface du revêtement (7), ou que seulement des zones de la pièce sont revêtues, pour permettre un assemblage par liaison de forme des composants (1, 2, 3, 3', 6).

3. Pièce micromécanique selon l'une des revendications précédentes, **caractérisée en ce que** le revêtement (7) joue le rôle d'un élément d'assemblage par liaison de forme pour les composants (1, 2, 3, 3', 6).

4. Pièce micromécanique selon l'une des revendications précédentes, **caractérisée en ce que** le revêtement (7) recouvre la surface de la pièce dans la zone des surfaces de contact des composants (1, 2, 3, 3', 6), en permettant de ce fait un assemblage de forme des composants.

5. Pièce micromécanique selon l'une des revendications précédentes, **caractérisée en ce que** le revêtement (7) est microcristallin ou nanocristallin.

6. Pièce micromécanique selon l'une des revendications précédentes, **caractérisée en ce que** le revêtement (7) est dopé, en particulier par du bore, de l'azote et/ou de l'ammoniac.

7. Pièce micromécanique selon l'une des revendications précédentes, **caractérisée en ce que** le revêtement (7) présente au moins l'une des propriétés suivantes :
- une résistance à la rupture en flexion σ₀ d'au moins 2 GPa, de préférence d'au moins 5 GPa et d'une manière particulièrement préférée d'au moins 7 GPa,
- un module d'élasticité au maximum de 1000 GPa, de préférence au maximum de 700 GPa et d'une manière particulièrement préférée au maximum de 500 GPa,
- une rugosité superficielle en moyenne quadratique de 3 à 100 nm, de préférence de 4 à 30 nm.

8. Pièce micromécanique selon l'une des revendications précédentes, **caractérisée en ce que** le revêtement (7) présente une épaisseur de couche comprise dans la plage de 1 à 100 µm, de préférence de 5 à 50 µpm et d'une manière particulièrement préférée de 10 à 30 µm, et est de préférence un revêtement obtenu par croissance isotrope.

9. Pièce micromécanique selon l'une des revendications précédentes, **caractérisée en ce que** les composants (1, 2, 3, 3', 6) sont chacun indépendamment des autres constitués de matériaux, ou pour l'essentiel les contiennent, qui sont choisis dans le groupe consistant en :
a) les métalloïdes, de préférence le carbone, le silicium ou le germanium ;
b) les matériaux métalliques, de préférence Fe, Ni, Cr, Co, Cu, Mn, V, Ti, Sc, W, Ta, Mo, Nb, Pt, Au, Rh ;
c) les alliages des matériaux métalliques mentionnés en b) ;
d) les carbures métalliques des métaux réfractaires Ti, Ta, W, Mo, Ni ;
e) les matériaux ferreux tels que l'acier ;
f) les matériaux composites à base de matériaux céramiques dans une matrice métallique (cermets), les métaux durs, les métaux durs à base de carbure frittés tels que les carbures de tungstène ou les carbures de titane liés au cobalt ou au nickel ;
g) les matériaux céramiques contenant du carbone et/ou de l'azote et/ou du bore et/ou de l'oxygène tels que par exemple le carbure de silicium, le nitrure de silicium, le nitrure de bore, les nitrures de titane, AIN, CrN, TiAlN, TiCN et/ou TiB₂, les vitrocéramiques, en particulier les vitrocéramiques au silicate d'aluminium, choisies de préférence dans le groupe consistant en le Zerodur, le Zerodur M et/ou le Zerodur K20 Saphir ;
h) le carbone, tel que par exemple le graphite, le diamant monocristallin, le diamant polycristallin, le diamant nanocristallin, et
i) des combinaisons des matériaux a) à h).

10. Pièce micromécanique selon l'une des revendications précédentes, **caractérisée en ce que** la pièce micromécanique de mouvement d'horlogerie appartient au groupe consistant en les ressorts de remontage, les ancres, les roues d'ancre, les composants de balancier, les plateaux, les roues dentées, les pignons, les pierres de coussinet, les contre-pivots, les pignons de coussinet, les tourillons, les axes, les ressorts, les ressorts de remontage, les ressorts de balancier, les balanciers et des combinaisons de ceux-ci, par exemple une roue dentée avec axe.

11. Procédé de fabrication d'une pièce micromécanique de mouvement d'horlogerie selon au moins l'une des revendications précédentes, comportant les étapes suivantes :
a) assemblage, par liaison de forme et/ou liaison dynamique, des composants (1, 2, 3, 3', 6), chaque composant étant mis en contact avec au moins un autre composant, par l'intermédiaire d'au moins une surface de contact,
b) nucléation en pleine surface ou par zones de la surface de la pièce avec des réactifs carbonés pour la formation de germes de diamant, et
c) croissance du diamant (7) par un dépôt chimique en phase vapeur CVD.

12. Procédé selon l'une des revendications 1 à 11, **caractérisé en ce qu'**un composant de la pièce est une roue dentée (1), comportant un logement d'axe élastique (10), et une deuxième pièce est un axe (2), l'axe étant dans un premier temps bloqué dans le logement d'axe, une fixation mécaniquement stable entre l'axe (2) et le coussinet (10) ayant lieu ensuite sous l'effet de la croissance du revêtement (7).

13. Procédé selon l'une des revendications 11 ou 12, **caractérisé en ce que** la fabrication a recours à la technologie des tranches, au cours de laquelle, avant l'étape a), un grand nombre de premiers composants (1, 2, 3, 3', 6) sont gravés sur une première tranche (13), et un grand nombre de deuxièmes composants (1, 2, 3, 3', 6) sont gravés sur une deuxième tranche (14), et sont ensuite assemblés sur la base des tranches.

14. Utilisation des pièces micromécaniques selon l'une des revendications 1 à 11 en tant que ressorts de remontage, d'ancres, de roues d'ancre, de pièces d'échappement, de plateaux, de roues dentées, de pignons, de pierres de coussinet, de contre-pivots, de pignons de coussinet, de tourillons, d'axes, de ressorts, de ressorts de remontage, de ressorts de balancier, de balanciers, d'aiguilles, d'index, de cadrans, de pièces de platine et de combinaisons de ceux-ci.
